Europäisches Patentamt

European Patent Office

Office européen des brevets

(11) Numéro de publication: **0 247 372**
**A1**

## (12) DEMANDE DE BREVET EUROPEEN

(21) Numéro de dépôt: 87106174.3

(22) Date de dépôt: 28.04.87

(51) Int. Cl.4: **H03K 17/62** , H03K 17/95

(30) Priorité: 29.04.86 FR 8606216

(43) Date de publication de la demande:
02.12.87 Bulletin 87/49

(84) Etats contractants désignés:
BE CH DE ES FR GB IT LI NL

(71) Demandeur: **AUTOMATISME & CONTROLE**
**8 Rue Raoul Follereau Zone Industrielle**
**"Pont du Rondeau" B.P. 18**
**F-38170 Seyssinet(FR)**

(72) Inventeur: **Revial, Jacques**
**63, Rue de Cartale**
**F-38170 Seyssinet Pariset(FR)**

(74) Mandataire: **Casalonga, Axel et al**
**BUREAU D.A. CASALONGA - JOSSE**
**Morassistrasse 8**
**D-8000 Munich 5(DE)**

(54) **Dispositif d'alimentation en courant continu et de sortie d'informations d'un circuit de detection.**

(57) Dispositif d'alimentation en courant continu et de sortie d'alimentation d'un circuit électronique de détection (2) à deux états de fonctionnement, comprenant deux connexions électriques (3, 4) destinées à être connectées à une source d'alimentation en courant continu (6) et une troisième (5) reliée à l'une des deux connexions d'alimentation par l'intermédiaire d'une charge extérieure (7, 8) en vue de fournir lesdites informations, un circuit électronique de commande (10), un circuit redresseur (9) relié auxdites connexions d'alimentation (3, 4) et alimentant les circuits électroniques de détection (2) et de commande (10) avec une polarité constante quelle que soit la polarité des connexions d'alimentation (3, 4), un circuit logique OU exclusif (11) dont les entrées (25, 26) sont reliées à l'une (4) des connexions d'alimentation et à la sortie (27) d'état de fonctionnement dudit circuit de détection (2), ledit circuit électronique de commande (10) comprenant un circuit interrupteur du type PNP (16) et un circuit interrupteur du type NPN (17) dont leur sortie est reliée à ladite troisième connexion (5) et un circuit de commutation (18) placé entre la sortie (20) dudit circuit logique OU exclusif (11) et les entrées de commande (23, 24) desdits circuits interrupteurs (16, 17) pour bloquer l'un de ces derniers et rendre l'autre conducteur et inversement suivant l'état de la sortie (20) dudit circuit logique OU exclusif (11).

FIG.1

## "DISPOSITIF D'ALIMENTATION EN COURANT CONTINU ET DE SORTIE D'INFORMATIONS D'UN CIRCUIT DE DETECTION"

La présente invention concerne un dispositif d'alimentation en courant continu et de sortie d'informations correspondant au signal de sortie d'un circuit électronique de détection.

Dans la technique actuelle des capteurs qui comprennent en général un circuit électronique de détection à deux états de fonctionnement, du type inductif, capacitif, optique ou autres, il est prévu entre la sortie du circuit de détection et la sortie proprement dite du capteur un circuit de commutation statique comprenant principalement un transistor. Les capteurs connus comprennent en générale, outre la connexion de sortie reliée audit transistor, deux connexions d'alimentation en courant continu, la charge extérieure recevant l'information correspondant à l'état de fonctionnement du circuit de détection, telle qu'un relais, l'entrée d'un automate programmable ou autres, étant montée entre la connexion de sortie et l'une des deux connexions d'alimentation en courant continu.

Si le transistor prévu dans le circuit de commutation est du type PNP, c'est-à-dire commutant le pôle positif de l'alimentation, la charge est alors reliée à son pôle négatif. Si par contre, le transistor est du type NPN, c'est-à-dire commutant le pôle négatif, la charge est alors reliée au pôle positif.

En outre, lorsque le circuit de détection est en position de détection, la charge extérieure peut être soit alimentée et dans ce cas le capteur est dit à fermeture, soit ne pas être alimentée et dans ce cas, le capteur est dit à ouverture. On distingue donc quatre-types de capteurs possibles.

A l'heure actuelle, on fabrique des capteurs dont chacun est conçu, au moment de sa fabrication, pour correspondre à l'un des types. On propose par ailleurs des capteurs susceptibles de correspondre à deux types, mais ces derniers doivent être commandés extérieurement par une quatrième connexion.

La présent invention propose au contraire un dispositif d'alimentation en courant continu et de sortie d'informations correspondant au signal de sortie d'un circuit électronique de détection susceptible de correspondre, à lui-seul, aux quatres types résultant des deux types de transistors et des deux types de fonctionnement de la charge extérieure.

Le dispositif d'alimentation en courant continu et de sortie d'informations correspondant au signal de sortie d'un circuit électronique de détection à deux états de fonctionnement, selon la présente invention, comprend trois connexions électriques dont deux sont destinées à être connectées à une source d'alimentation en courant continu et la troisième à l'une des deux connexions d'alimentation par l'intermédiaire d'une charge extérieure en vue de fournir lesdites informations à cette charge extérieure, ainsi qu'un circuit électronique de commande placé entre lesdites connexions électriques et ledit circuit de détection.

Le dispositif conforme à la présente invention est tel qu'il comprend un circuit redresseur relié auxdites connexions d'alimentation et adapté pour alimenter le circuit électronique de détection et le circuit électronique de commande avec une polarité constante quelle que soit la polarité des connexions d'alimentation ainsi qu'un circuit logique OU exclusif à deux entrées et une sortie, dont l'une des entrées est reliée à l'une des connexions d'alimentation et l'autre à la sortie d'état de fonctionnement dudit circuit de détection et que ledit circuit électronique de commande comprend un circuit interrupteur du type PNP et un circuit interrupteur du type NPN, dont leur sortie est reliée à ladite troisième connexion, et un circuit de commutation dont l'entrée est reliée à la sortie dudit circuit logique OU exclusif et dont les deux sorties sont reliées respectivement aux entrées de commande desdits circuits interrupteurs pour bloquer l'un de ces derniers et rendre l'autre passant et inversement suivant l'état de la sortie dudit circuit logique OU exclusif.

La présente invention sera mieux comprise à l'étude d'un dispositif d'alimentation en courant continu et de sortie d'informations d'un circuit électronique de détection décrit à titre d'exemple non limitatif et illustré par le dessin sur lequel :

-la figure 1 représente le schéma général d'un dispositif selon la présente invention ;

-et la figure 2 représente le schéma électronique d'une variante d'exécution possible du dispositif de la figure 1.

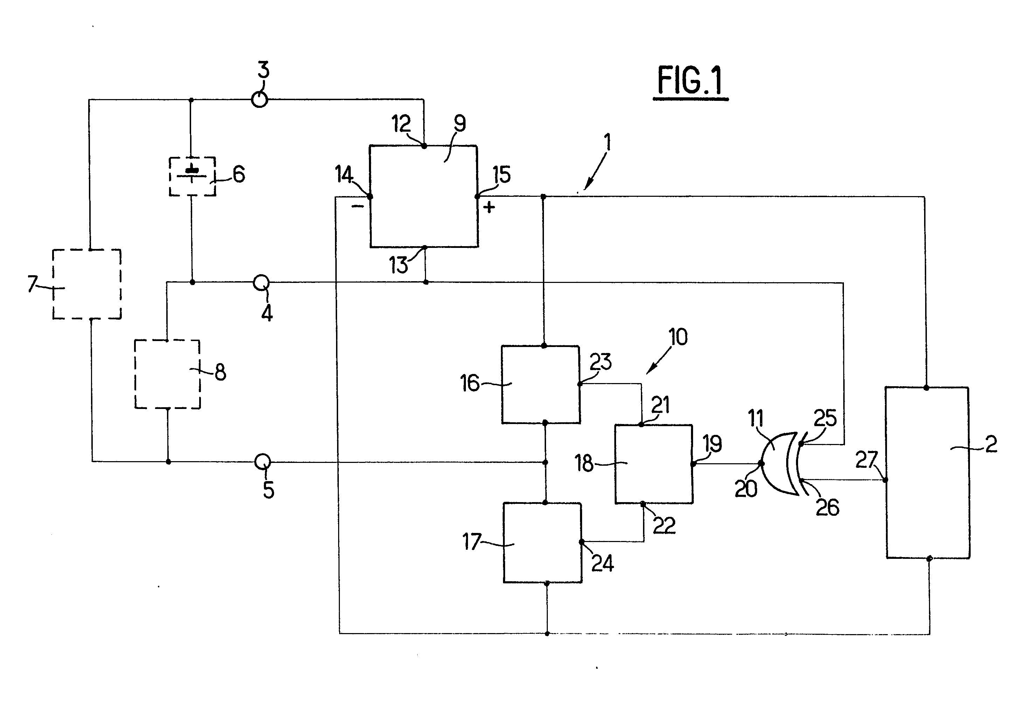

Le dispositif représenté sur la figure 1 et repéré d'une manière générale par la référence 1 est destiné à l'alimentation en courant continu et à la sortie d'informations correspondant au signal de sortie d'un circuit électronique de détection 2 à deux états de fonctionnement, par l'intermédiaire de trois connexions 3, 4, 5. Le dispositif de détection 2 peut être un dispositif de détection inductif, capacitif, optique ou tous autres dispositifs à deux états de fonctionnement.

Les connexions électriques 3 et 4 sont susceptibles d'être branchées sur une source extérieure d'alimentation en courant continu 6 et les informations correspondant au signal de sortie du circuit électronique de détection 2 sont disponibles entre la connexion d'alimentation 3 et la connexion de sortie 5 à l'aide d'une charge extérieure 7 ou entre la connexion d'alimentation 4 et la connexion de sortie 5 à l'aide d'une charge extérieure 8, les charges 7 et 8 pouvant être formées par des relais, les entrées d'un automate programmable ou tout autre dispositif faisant intervenir l'état de fonctionnement du circuit électronique de détection 2.

Le dispositif 1 comprend en outre un circuit redresseur 9, un circuit électronique de commande repéré d'une manière générale par la référence 10 ainsi qu'un circuit logique OU exclusif 11 à deux entrées et une sortie, qui sont montés entre les connexions 3, 4 et 5 et le circuit de détection 2 de la manière suivante.

Le circuit redresseur 9 comprend deux entrées d'alimentation 12 et 13 qui sont respectivement reliées aux connexions d'alimentation 3 et 4 ainsi que deux sorties d'alimentation 14 et 15 dont les polarités sont constantes quelles que soient les polarités des connexions d'alimentation 3 et 4, c'est-à-dire quel que soit le branchement de la source d'alimentation en énergie électrique 6. Dans l'exemple, la sortie d'alimentation 14 correspond à un pôle négatif et la sortie d'alimentation 15 correspond à un pôle positif.

Entre les sorties d'alimentation 14 et 15 du circuit redresseur 9, sont montés le circuit de détection 2 et le circuit électronique de commande 10 de telle sorte que ces derniers sont alimentés en courant continu avec une polarité constante quelle que soit la polarité des connexions d'alimentation en courant continu 3 et 4.

Le circuit électronique de commande 10 comprend, en série entre les sorties d'alimentation 14 et 15 du circuit redresseur 9, un circuit interrupteur du type PNP 16 et un circuit interrupteur du type NPN 17 dont le point connu est relié à la connexion de sortie 5.

Le circuit électronique de commande 10 comprend en outre un circuit de commutation 18 à une entrée et deux sorties dont l'entrée de commande 19 est reliée à la sortie 20 du circuit logique OU exclusif 11 et dont les deux sorties 21 et 22 sont respectivement reliées aux entrées de commande 23 et 24 des circuits interrupteurs 16 et 17. Ce circuit de commutation 18 est tel que suivant l'état de la sortie 20 du circuit logique ou exclusif 11, l'un des circuits interrupteurs 16 et 17 est bloqué tandis que l'autre est passant et inversement. Dans l'exemple, lorsque l'entrée 19 du circuit de commutation 18 reçoit une tension positive, le circuit interrupteur 16 est bloqué et le circuit interrupteur 17 est conducteur. Lorsque l'entrée 19 du circuit de commutation 18 est à zéro, c'est l'inverse qui se produit.

En outre, l'entrée 25 du circuit logique OU exclusif est reliée, dans l'exemple, à la connexion d'alimentation 4 et sa deuxième entrée 26 est reliée à la sortie d'état de fonctionnement 27 du circuit de détection 2 à deux états de fonctionnement.

On va maintenant décrire les quatre types de fonctionnement du dispositif 1 représenté sur la figure 1 suivant les modes de liaison des connexions d'alimentation en courant continu 3 et 4 et de la connexion de sortie 5, en supposant que pour le premier état de fonctionnement du circuit de détection 2 la tension à sa sortie 27 est nulle et que dans son second état de fonctionnement, la tension à sa sortie 27 est positive.

Dans un premier cas de montage, les connexions d'alimentation 3 et 4 sont respectivement reliées au pôle positif et au pôle négatif de la source de courant continu 6, avec la charge extérieure 8 branchée entre la connexion d'alimentation 4 et la connexion de sortie 5. Ce faisant, l'entrée 25 du circuit logique OU exclusif est à zéro et l'état de sa sortie 20 est l'image de son entrée 26 et est donc l'image de la sortie d'état de fonctionnement 27 du circuit de détection 2.

Quand la sortie 27 du circuit de détection 2 est à son premier état, c'est-à-dire à zéro, l'entrée 19 du circuit de commutation 18 est à zéro et en conséquence le circuit interrupteur PNP 16 est conducteur et le circuit interrupteur 17 est bloqué. Un courant circule alors dans la charge 8 de la connexion de sortie 5 vers la connexion d'alimentation 4, au travers du circuit redresseur 9 et du circuit interrupteur PNP 16.

Quand la sortie 27 du circuit de détection 2 est à son deuxième état, c'est-à-dire lorsqu'elle fournit une tension positive, le circuit de commutation 18 reçoit à son entrée 19 une tension positive et en conséquence le circuit interrupteur 16 est bloqué et le circuit interrupteur 17 est conducteur. En conséquence, aucun courant ne circule dans la charge 8.

On obtient ainsi un capteur à ouverture du type PNP.

Dans un deuxième cas de montage, les connexions d'alimentation 3 et 4 sont respectivement reliées au pôle négatif et au pôle positif de la source de courant continu 6, avec la charge extérieure 7 branchée entre la connexion d'alimentation 3 et la connexion de sortie 5. L'entrée 25 du circuit logique OU exclusif 11 est alors reliée au pôle positif de la source de courant continu 6 et reçoit donc une tension positive. Il s'ensuit que l'état de la sortie 20 du circuit logique OU exclusif est l'inverse de l'état de sa deuxième entrée 26.

Quand la sortie 27 du circuit de détection 2 est à son premier état, c'est-à-dire à zéro, l'entrée 19 du circuit de commutation 18 reçoit une tension positive et en conséquence le circuit interrupteur PNP 16 est bloqué et le circuit interrupteur 17 est conducteur. Le courant ne peut pas circuler dans la charge 7.

Quand la sortie 27 du circuit de détection 2 est à son deuxième état, c'est-à-dire lorsqu'elle fournit une tension positive, l'entrée 19 du circuit de commutation 18 est à zéro et en conséquence le circuit interrupteur 16 est conducteur et le circuit de commutation 17 est bloqué. Le courant circule alors dans la charge 7, entre la connexion de sortie 5 et la connexion d'alimentation 3, au travers du circuit redresseur 9 et du circuit interrupteur 16.

On obtient ainsi un capteur à fermeture du type PNP.

Dans un troisième cas de montage, les connexions d'alimentation 3 et 4 sont respectivement reliées au pôle positif et au pôle négatif de la source de courant continu 6, avec la charge extérieure 7 montée entre la connexion d'alimentation 3 et la connexion de sortie 5. L'entrée 25 du circuit logique OU exclusif est alors à zéro et la sortie 20 du circuit logique OU exclusif 11 est l'image de son entrée 26 comme dans le premier cas.

Quand la sortie 27 du circuit de détection 2 est à son premier état, c'est-à-dire à zéro, l'entrée 19 du circuit de commutation 18 est à zéro et en conséquence le circuit interrupteur 16 est conducteur et le circuit interrupteur NPN 17 est bloqué. Le courant ne peut pas circuler dans la charge 7.

Quand la sortie 27 du circuit de détection 2 est à son deuxième état, c'est-à-dire lorsqu'elle fournit une tension positive, le circuit de commutation 18 reçoit sur son entrée 19 une tension positive et en conséquence le circuit interrupteur 16 est bloqué et le circuit interrupteur NPN 17 est conducteur. Le courant circule alors dans la charge 7 entre la connexion de sortie 5 et la connexion d'alimentation 3, et au travers du circuit interrupteur 17 et du circuit redresseur 9.

On obtient ainsi un capteur à fermeture du type NPN.

Dans un quatrième cas de montage, on relie les connexions d'alimentations 3 et 4 au pôle négatif et au pôle positif de la source de courant continu 6, avec la charge 8 montée entre la connexion de sortie 5 et la connexion d'alimentation 4. L'entrée 25 du circuit logique OU exclusif 11 est reliée au pôle positif et en conséquence l'état de sa sortie 20 est l'inverse de l'état de son entrée 26.

Quand la sortie 27 du circuit de détection 2 est à son premier état, c'est-à-dire à zéro, l'entrée 19 du circuit de commutation 18 est positive et en conséquence la circuit interrupteur 16 est bloqué et le circuit interrupteur NPN 17 est conducteur. Le courant peut alors circuler dans la charge 8 et au travers du circuit interrupteur 17 et du circuit redresseur 9 vers la connexion d'alimentation 3.

Quand la sortie 27 du circuit de détection 2 est à son deuxième état, c'est-à-dire lorsqu'elle fournit une tension positive, l'entrée 19 du circuit de commutation 18 est à zéro et en conséquence le circuit interrupteur 16 est conducteur et le circuit interrupteur NPN 17 est bloqué. Le courant ne peut donc pas circuler dans la charge 8.

On obtient ainsi un capteur à ouverture du type NPN.

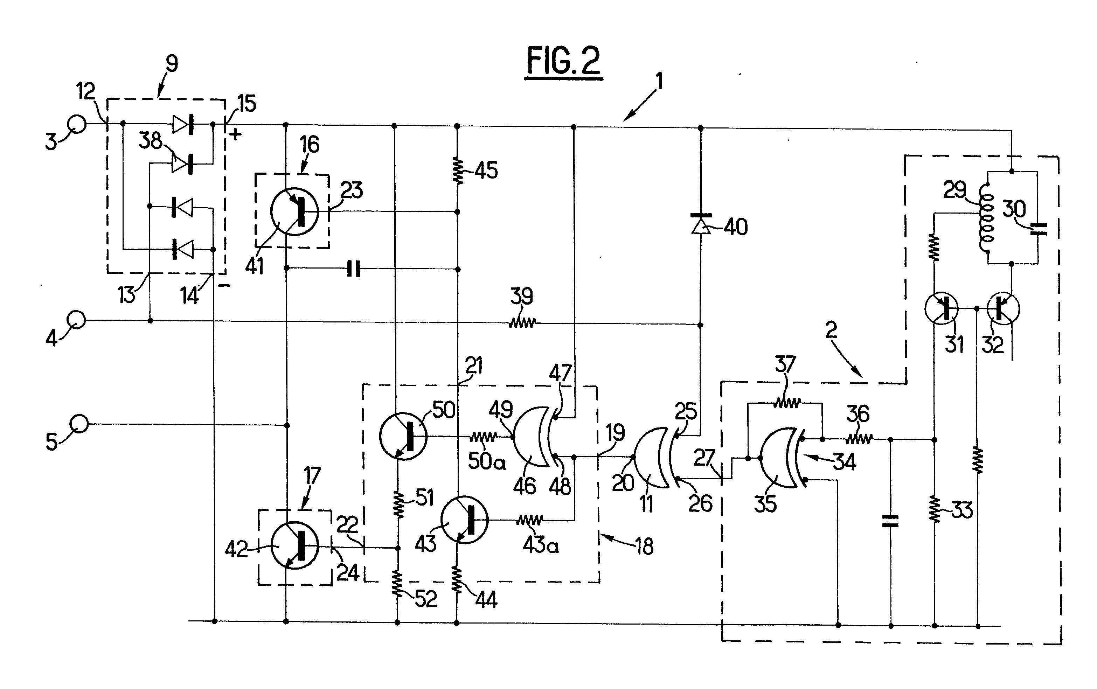

En se reportant à la figure 2, on va maintenant décrire une réalisation pratique des différentes parties constituant le dispositif représenté sur la figure 1.

Dans cet exemple de réalisation, le circuit de détection 2 est un détecteur de proximité inductif 28 d'un type classique comprenant en parallèle une bobine 29 et une capacité associée à deux transistors 31 et 32, de manière à former un oscillateur. En l'absence d'une pièce métallique à proximité de la bobine 29, la tension aux bornes de la résistance 33 est positive et en présence d'une pièce métallique à proximité de la bobine 29, l'oscillateur 28 se bloque et la tension aux bornes de la résistance 33 devient proche de zéro.

Aux bornes de cette résistance 33 est monté un circuit à seuil 34 qui comprend un circuit logique OU exclusif 35 dont les deux entrées sont respectivement reliées aux bornes de la résistance 33, l'une directement et l'autre par l'intermédiaire d'une résistance 36, la sortie du circuit logique ou exclusif 35 étant reliée à son entrée associée à la résistance 36 par l'intermédiaire d'une résistance 37. L'état de la sortie 27 du circuit de détection 2 correspond à l'état de la sortie du circuit logique OU exclusif 35 du circuit à seuil 34.

Le circuit redresseur 9 comprend quatre diodes 38 montées en pont, de manière classique, entre ses entrées d'alimentation 12 et 13 reliées respectivement aux connexions 3 et 4 et ses sorties d'alimentation 14 et 15 de telle sorte que, dans l'exemple, la sortie d'alimentation 14 corresponde à un pôle négatif et la sortie d'alimentation 15 corresponde à un pôle positif quelle que soit la polarité de ses entrées 12 et 13.

Le circuit de détection 2 décrit plus haut est branché, en vue de son alimentation à polarité constante, entre les sorties d'alimentation 14 et 15 du circuit redresseur 9.

La seconde entrée 26 du circuit logique OU exclusif 11 est reliée à la sortie 27 du circuit de détection 2 tandis que son entrée 25 est reliée à la connexion d'alimentation 4 par l'intermédiaire d'une résistance 39 et est également reliée à la sortie d'alimentation 15 du circuit redresseur 9 via une diode 40.

Le circuit interrupteur 16 comprend un transistor PNP 41 dont l'émetteur est relié à la sortie d'alimentation 15 du circuit redresseur 9 et le circuit interrupteur 17 comprend un transistor NPN 42 dont l'émetteur est relié à la sortie d'alimentation 14 du circuit redresseur 9, les collecteurs de ces transistors 41 et 42 étant reliés à la connexion de sortie 5 tandis que leurs bases constituent respectivement les entrées de commande 23 et 24 des circuits interrupteurs 16 et 17.

Le circuit de commutation 18 comprend un transistor NPN 43 dont l'émetteur et le collecteur sont respectivement reliés aux sorties d'alimentation 14 et 15 du circuit redresseur 9 via des résistances 44 et 45, la base du transistor 43 étant reliée à la sortie du circuit logique OU exclusif 11 via l'entrée de commande 19 du circuit de commande 10 et par l'intermédiaire d'une résistance 43a et son collecteur étant relié à la base du transistor PNP 41 via l'entrée de commande 23 du circuit interrupteur 16.

Le circuit de commutation 18 comprend en outre un circuit logique OU exclusif 46 à deux entrées et une sortie dont l'une des entrées 47 est reliée à la sortie d'alimentation 15 du circuit redresseur 9 et dont l'autre entrée 48 est reliée à la sortie du circuit logique OU exclusif 11 via l'entrée de commande 19 du circuit de commutation 18, et dont la sortie 49 attaque la base d'un transistor NPN 50, via une résistance 50a, dont le collecteur est relié à la sortie d'alimentation 15 du circuit redresseur 9 et dont l'émetteur est relié à la sortie d'alimentation 14 de ce dernier au travers de deux résistances 51 et 52 dont le point commun est relié à la base du transistor NPN 42 via l'entrée de commande 24 du circuit interrupteur 17. Le circuit logique OU exclusif 46 constitue un inverseur du signal de sortie du circuit logique OU exclusif 11 et les transistors 43 et 50 sont prévus pour que la base des transistors 41 et 42 soit attaquée par une puissance suffisante.

Le dispositif qui vient d'être décrit en référence à la figure 2 fonctionne exactement de la même manière que le circuit décrit en référence à la figure 1 et est adapté pour réaliser les quatres cas de montage sur les connexions 3, 4 et 5 examinés plus hautet les quatre types de fonctionnement qui en découlent. Bien entendu, le détecteur de proximité inductif constituant le circuit de détection 2 pourrait être remplacé par tout autre circuit de détection fournissant à sa sortie deux états de fonctionnement.

La présente invention ne se limite pas à l'exemple ci-dessus décrit. Bien d'autres variantes de réalisation sont possibles sans sortir du cadre défini par les revendications annexées.

## Revendications

1. Dispositif d'alimentation en courant continu et de sortie d'informations correspondant au signal de sortie d'un circuit électronique de détection (2) à deux états de fonctionnement, comprenant trois connexions électriques dont deux (3, 4) sont destinées à être connectées à une source d'alimentation en courant continu (6) et la troisième (5) à l'une des deux connexions d'alimentation par l'intermédiaire d'une charge extérieure en vue de fournir lesdites informations à cette charge extérieure, ainsi qu'un circuit électronique de commande (10) placé entre lesdites connexions électriques et ledit circuit de détection (2), caractérisé par le fait qu'il comprend un circuit redresseur (9) relié auxdites connexions d'alimentation (3, 4) et adapté pour alimenter le circuit électronique de détection (2) et le circuit électronique de commande (10) avec une polarité constante quelle que soit la polarité des connexions d'alimentation (3, 4) ainsi qu'un circuit logique OU exclusif (11) à deux entrées et une sortie, dont l'une (25) des entrées est reliée à l'une (4) des connexions d'alimentation et l'autre (26) à la sortie (27) d'état de fonctionnement dudit circuit de détection (2) et que ledit circuit électronique de commande (10) comprend un circuit interrupteur du type PNP (16) et un circuit interrupteur du type NPN (17) dont leur sortie est reliée à ladite troisième connexion (5) et un circuit de commutation (18) dont l'entrée (19) est reliée à la sortie (20) dudit circuit logique OU exclusif (11) et dont les deux sorties (21 et 22) sont respectivement reliées aux entrées de commande (23, 24) desdits circuits interrupteurs (16, 17) pour bloquer l'un de ces derniers et rendre l'autre conducteur et inversement suivant l'état de la sortie (20) dudit circuit logique OU exclusif (11).

2. Dispositif selon la revendication 1, caractérisé par le fait que ledit circuit redresseur (9) comprend quatre diodes (38) montées en pont.

3. Dispositif selon l'une des revendications 1 et 2, caractérisé par le fait que lesdits circuits interrupteurs (16, 17) comprennent respectivement un transistor PNP (41) et un transistor NPN (42) dont les émetteurs sont respectivement reliés aux sorties d'alimentation (14, 15) dudit circuit redresseur (9) et dont les bases sont respectivement reliées aux sorties de commande dudit circuit de commande dudit circuit de commutation (18).

4. Dispositif selon l'une quelconque des revendications précédentes, caractérisé par le fait que ledit circuit de commutation (18) comprend deux transistors de commande desdits circuits interrupteurs (16, 17) dont l'un (43) est commandé directement par la sortie (20) du circuit logique OU exclusif (11) et dont l'autre est commandé par cette sortie (20) via un inverseur (46).

FIG.1

0 247 372

# FIG.2

0 247 372

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl 4) |
|---|---|---|---|
| E | EP-A-0 227 966 (SIEMENS)<br>* Colonne 1, ligne 50 - colonne 2, ligne 47; figure 1 * | 1 | H 03 K 17/62<br>H 03 K 17/95 |
| A | | 3 | |
| | --- | | |
| Y | DE-A-3 342 710 (WERNER TURCK GmbH)<br>* Colonne 4, ligne 54 - colonne 5, ligne 4; colonne 6, lignes 12-19; colonne 8, ligne 23 - colonne 9, ligne 11; figures 2,4,5,7 * | 1 | |
| A | | 2 | |
| | --- | | DOMAINES TECHNIQUES RECHERCHES (Int. Cl.4) |
| Y | DE-A-3 111 659 (KASTL KG)<br>* Page 14, ligne 12 - page 16, ligne 13; page 17, lignes 9-25; figures 1,2 * | 1 | H 03 K 17/00<br>G 01 R 19/00 |
| A | | 3,4 | |
| | --- | | |
| Y | PATENT ABSTRACTS OF JAPAN, vol. 6, no. 103 (E-112)[981], 12 juin 1982; & JP-A-57 33 831 (YAMATAKE HONEYWELL K.K.) 24-02-1982<br>* Résumé; figure * | 1 | |
| | ---              -/- | | |

Le présent rapport de recherche a été établi pour toutes les revendications

| Lieu de la recherche | Date d'achèvement de la recherche | Examinateur |
|---|---|---|
| LA HAYE | 01-09-1987 | TRELEVEN C. |

## Office européen des brevets

## RAPPORT DE RECHERCHE EUROPEENNE

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | EP-A-0 096 332 (SIEMENS)<br>* Page 3, ligne 19 - page 4, ligne 25; figure 1 * | 1 | |
| A | GB-A-2 117 204 (SGS-ATES COMPONENTS)<br>* Page 2, lignes 29-106; figures 2 * | 3,4 | |

DOMAINES TECHNIQUES RECHERCHES (Int. Cl.4)

Le présent rapport de recherche a été établi pour toutes les revendications

| Lieu de la recherche | Date d'achèvement-de la recherche | Examinateur |
|---|---|---|
| LA HAYE | 01-09-1987 | TRELEVEN C. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié a la date de dépôt ou après cette date
D : cité dans la demande
L : cité pour d'autres raisons

& : membre de la même famille, document correspondant

OEB Form 1503 03 82